# EUROPEAN PATENT APPLICATION

(11) **EP 4 770 396 A1**
(43) Date of publication of application: **01.07.2026**
(21) Application number: 25219604.3
(22) Date of filing: 30.11.2025
(51) Int. Cl.: H10K 59/80, H10K 59/131

(54) **LIGHT EMITTING DISPLAY APPARATUS**

(30) Priority: 30.12.2024 KR 20240201447
(71) Applicant: LG Display Co., Ltd., Seoul, 07336 (KR)
(72) Inventor: SEO, YeongRae, 10845 Paju-si (KR); RYU, Youngwan, 10845 Paju-si (KR); CHAE, Jieun, 10845 Paju-si (KR)
(74) Representative: Ter Meer Steinmeister & Partner

(57) **Abstract**

A light emitting display apparatus may include a substrate including a display area and a non-display area surrounding the display area, at least one insulating layer on the substrate, a power voltage shorting line on the at least one insulating layer in the non-display area, a plurality of dam patterns in the non-display area, each comprising one or more organic materials and overlapping the power voltage shorting line, and a cover pattern between the plurality of dam patterns and covering an edge portion of the power voltage shorting line.

## Description

This application claims priority to Republic of Korea Patent Application No. 10-2024-0201447 filed on December 30, 2024.

### BACKGROUND

### Technical Field

The disclosure relates to a light emitting display apparatus.

### Description of the Related Art

With the development of information society, the demand for a display apparatus for displaying images has been increasing in various forms. Accordingly, display apparatuses such as a liquid crystal display (LCD) apparatus, an organic light emitting display (OLED) apparatus, a micro light emitting diode display (micro-LED) apparatus, a quantum dot display (QD) apparatus, and the like are used.

The light emitting display apparatus may form an encapsulation layer to block the infiltration of moisture or oxygen from the outside. The encapsulation layer may include at least one inorganic layer and at least one organic layer to prevent the infiltration of moisture and oxygen.

### SUMMARY

The light emitting display apparatus may cause an organic layer with fluidity to overflow into a bezel region of the display panel during the process of forming the encapsulation layer. To prevent this, the bezel region of the display panel includes a dam structure that blocks the flow of the organic layer.

However, the dam structure may experience a reduction in the adhesion properties of the organic material in a high-temperature and high-humidity environment, which may cause the layer to lift. As a result, cracks may form in the encapsulation layer, and moisture may penetrate through the cracks, causing corrosion of the signal voltage line crossing the dam structure and leading to electrolytic corrosion failure.

One object is to provide a light emitting display apparatus capable of preventing or at least reducing moisture from penetrating through the bezel region of the display panel.

One object is to provide a light emitting display device capable of preventing or at least reducing lifting or cracking defects of the encapsulation layer in the bezel region.

One object is to provide a light emitting display device capable of preventing electrolytic corrosion failure of a signal voltage line disposed in the bezel region.

One object is to provide a light emitting display device with improved reliability in a high-temperature and high-humidity environment.

Additional advantages and features of the disclosure will be set forth in part in the description which follows and in part will become apparent to those having ordinary skill in the art upon examination of the following or may be learned from practice of the disclosure. The objectives and other advantages of the disclosure may be realized and attained by the structure particularly pointed out in the written description and claims hereof as well as the appended drawings.

The object is solved by the features of the independent claims. Preferred embodiments are given the dependent claims.

In one embodiment, a light emitting display apparatus comprises: a substrate including a display area and a non-display area outside the display area; at least one insulating layer on the substrate; a power voltage shorting line that supplies a power voltage, the power voltage shorting line is provided on the at least one insulating layer in the non-display area; a dam patterns in the non-display area, the dam pattern comprising one or more organic materials and overlaps the power voltage shorting line; and a cover pattern between the dam pattern in the non-display area, the cover pattern covering an edge portion of the power voltage shorting line.

In another embodiment, a light emitting display apparatus comprises: a substrate including a display area and a non-display area surrounding or outside the display area; at least one insulating layer on the substrate; a power voltage shorting line that supplies a power voltage, the power voltage shorting line on the at least one insulating layer in the non-display area; a plurality of dam patterns in the non-display area, each of the plurality of dam patterns comprising one or more organic materials and overlaps the power voltage shorting line; and a cover pattern between the plurality of dam patterns in the non-display area, the cover pattern covering an edge portion of the power voltage shorting line.

In the following optional features will be provided which might be combined with the above mentioned aspect alone or in combination or sub-combination.

In one or more embodiments, the power voltage shorting line and the plurality of dam patterns may intersect each other in a plan view.

In one or more embodiments, the plurality of dam patterns may extend in a first direction and the power voltage shorting line may extend in a second direction that is different from the first direction.

In one or more embodiments, the power voltage shorting line may include a fine protrusion pattern at the edge portion covered by the cover pattern.

In one or more embodiments, the fine protrusion pattern may include a hammer shape.

In one or more embodiments, the hammer shape may include a handle portion and a head portion at an end of the handle portion.

In one or more embodiments, the head portion may have a width wider than a width of the handle portion.

In one or more embodiments, the cover pattern may comprise an organic material different from the one or more organic materials of the plurality of dam patterns.

In one or more embodiments, the cover pattern may be an island pattern that covers the edge portion of the power voltage shorting line but does not cover another edge portion of the power voltage shorting line that is spaced apart from the edge portion.

In one or more embodiments, the cover pattern may include a first cover pattern and a second cover pattern.

In one or more embodiments, the first cover pattern may cover the edge portion of the power voltage shorting line and the second cover pattern covers the other edge portion of the power voltage shorting line.

In one or more embodiments, the plurality of dam patterns may include a first dam pattern adjacent to the display area, the first dam pattern comprising a plurality of organic materials; and a second dam pattern adjacent to an edge of the substrate.

In one or more embodiments, the second dam pattern may be closer to the edge of the substrate than the first dam pattern.

In one or more embodiments, the first dam pattern may be closer to the display area than the second dam pattern.

In one or more embodiments, the second dam pattern may comprise a plurality of organic materials.

In one or more embodiments, the cover pattern may be between the first dam pattern and the second dam pattern:

In one or more embodiments, the cover pattern may comprise an organic material that is different from the plurality of organic materials of the first dam pattern and the plurality of organic materials of the second dam pattern.

In one or more embodiments, the plurality of dam patterns may further include at least one sub-dam pattern between the first dam pattern and the second dam pattern.

In one or more embodiments, the at least one sub-dam pattern may comprise an organic material that is different from the organic material of the cover pattern.

In one or more embodiments, the cover pattern may overlap at least a portion of the at least one sub-dam pattern and the at least one sub-dam pattern is on the cover pattern.

In one or more embodiments, the cover pattern may include a material having better adhesion to the power voltage shorting line than a material of the at least one sub-dam pattern.

In one or more embodiments, the cover pattern may be non-overlapping with the at least one sub-dam pattern.

In one or more embodiments, the at least one sub-dam pattern may have a closed loop shape between the first dam pattern and the second dam pattern.

In one or more embodiments, the power voltage shorting line may include a first power voltage shorting line that supplies a high potential power voltage; and a second power voltage shorting line that supplies a low potential power voltage lower than the high potential power voltage.

In one or more embodiments, the at least one sub-dam pattern may be non-overlapping with the first power voltage shorting line and overlapping with the second power voltage shorting line.

In one or more embodiments, the at least one sub-dam pattern may include a first sub-dam pattern and a second sub-dam pattern that are spaced apart from each other and are parallel to each other.

In one or more embodiments, the cover pattern may overlap with the first sub-dam pattern and the second sub-dam pattern.

In one or more embodiments, the cover pattern may have a closed-loop shape and may cover a first side edge and a second side edge of the power voltage shorting line.

In one or more embodiments, each of the first dam pattern and the second dam pattern may extend in a first direction.

In one or more embodiments, the cover pattern may further include a sub-cover pattern protruding from each of the first dam pattern and the second dam pattern in a second direction that is different from the first direction.

In one or more embodiments, the light emitting display apparatus may comprise a planarization layer on the at least one insulating layer in the display area; a light-emitting device on the planarization layer, the light-emitting device comprising a pixel electrode, an emission layer, and a common electrode; a pixel circuit between the substrate and the planarization layer, the pixel circuit connected to the light-emitting device; a bank layer between the pixel electrode and the emission layer, the bank layer including an opening area of the pixel electrode; and an encapsulation portion that covers the light-emitting device and the bank layer.

In one or more embodiments, the power voltage shorting line may supply the power voltage to a first power voltage line connected to the pixel circuit.

In one or more embodiments, the plurality of dam patterns may comprise a same material as at least a portion of the planarization layer and the bank layer.

In one or more embodiments, the cover pattern may comprise a same material as the planarization layer.

In one or more embodiments, the plurality of dam patterns may include at least one sub-dam pattern comprising a same material as the bank layer.

In one or more embodiments, the cover pattern may overlap the at least one sub-dam pattern.

In one or more embodiments, the non-display area may further include a pad area.

In one or more embodiments, the light emitting display apparatus may include a plurality of voltage signal lines extending from the pad area.

In one or more embodiments, there may be a plurality of voltage signal lines between the power voltage shorting line and the substrate.

In one or more embodiments, the plurality of dam patterns and the power voltage shorting line may be between the display area and the pad area.

According to one or more embodiments of the present disclosure, a light emitting display apparatus capable of preventing moisture from penetrating through the bezel region of the display panel, may be provided.

According to one or more embodiments of the present disclosure, a light emitting display apparatus capable of preventing lifting or cracking defects of the encapsulation layer in the bezel region, may be provided.

According to one or more embodiments of the present disclosure, a light emitting display apparatus capable of preventing electrolytic corrosion failure of a signal voltage line disposed in the bezel region, may be provided.

According to one or more embodiments of the present disclosure, a light emitting display apparatus with improved reliability in a high-temperature and high-humidity environment, may be provided.

The light emitting display apparatus according to one or more embodiments of the disclosure may prevent the lifting or cracking defects of the encapsulation layer in the bezel region of the display panel, and may prevent moisture from penetrating through the bezel region. Accordingly, electrolytic corrosion failure of the signal voltage line disposed in the bezel region may be prevented, and reliability in high-temperature and high-humidity environments may be improved. As a result, the manufacturing process of the light emitting display apparatus may be optimized, power consumption may be reduced for low-power operation, and the lifespan of the apparatus may be extended, thereby enabling the implementation of Environment/Social/Governance (ESG) by reducing energy consumption during production.

The effects of the disclosure are not limited to the aforesaid, but other effects not described herein will be clearly understood by those skilled in the art from the following descriptions.

The details of the disclosure described in technical problem, technical solution, and advantageous effects do not specify essential features of claims, and thus, the scope of claims is not limited by the details described in detailed description of the invention.

### BRIEF DESCRIPTION OF THE DRAWINGS

The accompanying drawings, which are included to provide a further understanding of the disclosure, are incorporated in and constitute a part of this disclosure, illustrate aspects and embodiments of the disclosure, and together with the description serve to explain the principles and examples of the disclosure.
FIG. 1 illustrates a schematic configuration of a light emitting display apparatus of an embodiment of the disclosure.
FIG. 2 illustrates a light emitting display apparatus of an embodiment of the disclosure.
FIG. 3 illustrates a region A shown in FIG. 2 of an embodiment of the disclosure.
FIG. 4 is a cross-sectional view taken along line I-I' of FIG. 3 of an embodiment of the disclosure.
FIG. 5 illustrates a region B shown in FIG. 3 of an embodiment of the disclosure.
FIG. 6 is a cross-sectional view taken along line II-II' of FIG. 5 of an embodiment of the disclosure.
FIG. 7 illustrates a region B shown in FIG. 3 of one embodiment of the disclosure.
FIG. 8 is a cross-sectional view taken along line III-III' of FIG. 7 of one embodiment of the disclosure.
FIG. 9 illustrates a region B shown in FIG. 3 of another embodiment of the disclosure.
FIG. 10 is a cross-sectional view taken along line IV-IV' of FIG. 9 of another embodiment of the disclosure.
FIG. 11 illustrates a region B shown in FIG. 3 of another embodiment of the disclosure.

Throughout the drawings and the detailed description, unless otherwise described, the same drawing reference numerals should be understood to refer to the same elements, features, and structures. The sizes, lengths, and thicknesses of layers, regions and elements, and depiction of thereof may be exaggerated for clarity, illustration, and/or convenience.

### DETAILED DESCRIPTION

Advantages and features of the present disclosure, and implementation methods thereof, are clarified through the embodiments described with reference to the accompanying drawings. The present disclosure may, however, be embodied in different forms and should not be construed as limited to the embodiments set forth herein. Rather, these embodiments are examples and are provided so that this disclosure may be thorough and complete, to assist those skilled in the art to understand the inventive concepts without limiting the protected scope of the disclosure.

Shapes (e.g., sizes, lengths, widths, heights, thicknesses, locations, radii, diameters, and areas), sizes, ratios, angles, numbers, and the like disclosed herein, including those illustrated in the drawings are merely examples, and thus, the present disclosure is not limited to the illustrated details. Any implementation described herein as an "example" is not necessarily to be construed as preferred or advantageous over other implementations. It is, however, noted that the relative dimensions of the components illustrated in the drawings are part of the present disclosure.

When the term "comprise," "have," "include," "contain," "constitute," "made of," "formed of," or the like is used with respect to one or more elements, one or more other elements may be added unless a term such as "only" or the like is used. The terms used in the disclosure are merely used in order to describe embodiments, and are not intended to limit the scope of the disclosure. The terms of a singular form may include plural forms unless the context clearly indicates otherwise.

In construing an element, the element is construed as including an error region although there is no explicit description thereof.

In describing a positional relationship, for example, when the positional order is described as "on," "above," "below," "beneath", and "next," the case of no contact therebetween may be included, unless "just" or "direct" is used.

If it is mentioned that a first element is positioned "on" a second element, it does not mean that the first element is essentially positioned above the second element in the figure. The upper part and the lower part of an object concerned may be changed depending on the orientation of the object. Consequently, the case in which a first element is positioned "on" a second element includes the case in which the first element is positioned "below" the second element as well as the case in which the first element is positioned "above" the second element in the figure or in an actual configuration.

In describing a temporal relationship, for example, when the temporal order is described as "after," "subsequent," "next," and "before," a case which is not continuous may be included, unless "just" or "direct" is used.

It will be understood that, although the terms "first," "second," etc. may be used herein to describe various elements, these elements should not be limited by these terms. These terms are only used to distinguish one element from another. For example, a first element could be termed a second element, and, similarly, a second element could be termed a first element.

In describing elements of the disclosure, the terms "first," "second," "A," "B," "(a)," "(b)," or the like may be used. These terms are intended to identify the corresponding element(s) from the other element(s), and these are not used to define the essence, basis, order, or number of the elements.

For the expression that an element is "connected," "coupled," "attached," "adhered," or the like to another element, the element may not only be directly connected, coupled, attached, adhered, or the like to another element, but also be indirectly connected, coupled, attached, adhered, or the like to another element with one or more intervening elements disposed or interposed between the elements, unless otherwise specified.

For the expression that an element is "contacts," "overlaps," or the like with another element, the element may not only directly contact, overlap, or the like with another element, but also indirectly contact, overlap, or the like with another element with one or more intervening elements disposed or interposed between the elements, unless otherwise specified.

The term "at least one" should be understood as including any and all combinations of one or more of the associated listed items. For example, "at least one among a first element, a second element and a third element" may include all combinations of two or more elements selected from the first, second and third elements as well as each element of the first, second and third elements.

Features of various embodiments of the disclosure may be partially or entirety coupled to or combined with each other, may be technically associated with each other, and may be variously inter-operated, linked or driven together. The embodiments of the disclosure may be implemented or carried out independently of each other, or may be implemented or carried out together in a co-dependent or related relationship. In one or more aspects, the components of each apparatus according to various embodiments of the disclosure are operatively coupled and configured.

In the following description, various embodiments of the disclosure are described in detail with reference to the accompanying drawings. With respect to reference numerals to elements of each of the drawings, the same elements may be illustrated in other drawings, and like reference numerals may refer to like elements unless stated otherwise. The same or similar elements may be denoted by the same reference numerals even though they are depicted in different drawings. In addition, for convenience of description, a scale, dimension, size, and thickness of each of the elements illustrated in the accompanying drawings may be different from an actual scale, dimension, size, and thickness, and thus, embodiments of the present disclosure are not limited to a scale, dimension, size, and thickness illustrated in the drawings.

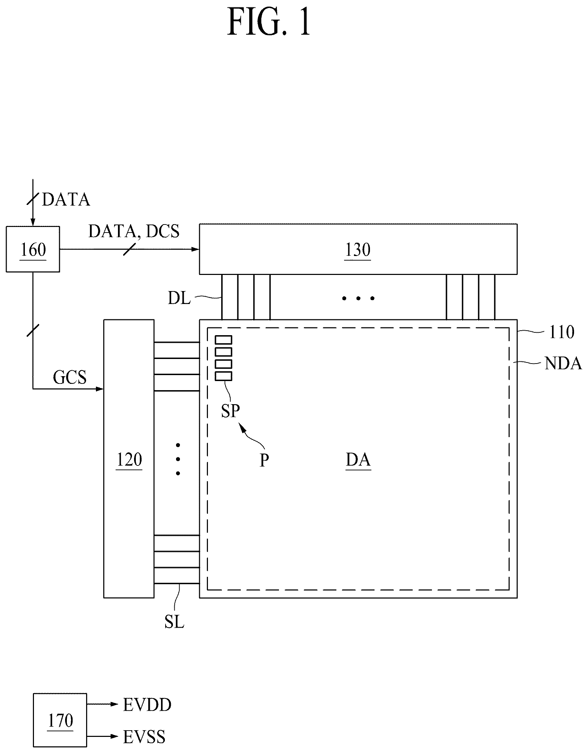

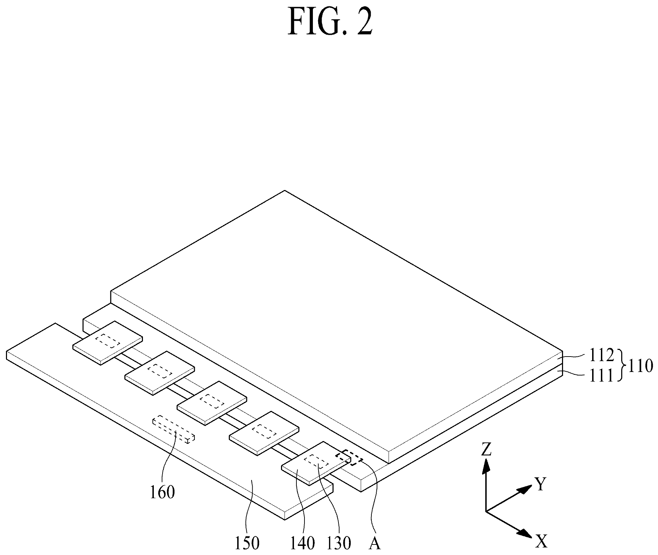

FIG. 1 illustrates a schematic configuration of a light emitting display apparatus of an embodiment of the disclosure. FIG. 2 illustrates a light emitting display apparatus of an embodiment of the disclosure.

Hereinafter, X-axis represents a direction parallel with a scan line (or a gate line), Y-axis represents a direction parallel with a data line, and Z-axis represents a height direction of the light emitting display apparatus.

A light emitting display apparatus of an embodiment of the disclosure is implemented as an OLED apparatus, but may also be implemented as a LCD apparatus, a quantum dot lighting emitting diode display apparatus, or an electrophoretic display apparatus.

Referring to FIGS. 1 and 2, the light emitting display apparatus of an embodiment of the disclosure may include a display panel 110, a scan driver 120 (or a gate driver) embedded in the display panel 110, a data driver 130 connected to the display panel 110, a timing controller 160 controlling the scan driver 120 and the data driver 130, and a power circuit 170.

The display panel 110 may include a substrate 111 and an opposite substrate 112. The opposite substrate 112 may be an encapsulation substrate. The substrate 111 may include a plastic film or a glass substrate, but embodiments of the present disclosure are not limited thereto. For example, the substrate 111 may comprise a semiconductor material, such as a silicon wafer. The opposite substrate 112 may be a plastic film, a glass substrate, or an encapsulation film (or protective film).

The display panel 110 includes a display area DA and a non-display area NDA surrounding the display area DA. The display panel 110 includes pixels P provided in the display area DA to display an image. Each of the pixels P may include a plurality of subpixels SP. The structure of the subpixel SP may be variously changed according to the type of the light emitting display apparatus 100. For example, the subpixels SP may be formed in a top emission type, a bottom emission type, or a dual emission type according to the structure. The subpixels SP indicate a unit capable of forming a color filter of a specific type or capable of emitting a color of itself without forming a color filter. The subpixels SP may have one or more other light-emitting areas according to light-emitting characteristics. For example, the plurality of subpixels SP may be arranged in a quad type or a stripe type, but embodiments of the present disclosure are not limited thereto. The color type, arrangement type, arrangement order, and the like of the subpixels SP may be configured in various forms according to the light-emitting characteristics, lifespan of the apparatus, spec of the apparatus, and the like.

The display panel 110 may include data lines DL and scan lines SL (or gate lines) connected to the subpixels SP. The data lines DL may be arranged to cross the scan lines SL. Each of the subpixels SP of the display panel 110 may be connected to any one of the data lines DL and any one of the scan lines SL. The data lines DL may supply a data voltage supplied from the data driver 130 to each of the subpixels SP. The scan lines SL may supply a scan signal supplied from the scan driver 120 to each of the subpixels SP.

Each of the subpixels SP is turned-on by the scan signal. When the data voltage of the data line DL is supplied to a gate electrode of a driving transistor, a light emitting element may emit light according to a drain-to-source current of the driving transistor. The scan driver 120 may receive a scan control signal GCS from the timing controller 160. The scan driver 120 may supply the scan signals or emission control signal to the scan lines SL by using the scan control signal GCS.

The scan driver 120 may be configured in a gate driver in panel GIP manner in the non-display area NDA outside one side or both sides of the display area DA. Alternatively, the scan driver 120 may be manufactured as a driving chip, mounted on a flexible film, and attached to the non-display area NDA outside one side or both sides of the display area DA in a tape automated bonding TAB manner.

The data driver 130 may receive digital video data DATA and a data control signal DCS from the timing controller 160. The data driver 130 converts the digital video data DATA into analog positive/negative data voltages by using the data control signal DCS and supplies the analog positive/negative data voltages to the data lines DL.

The data driver 130 may include a plurality of source drive ICs (source drive integrated circuits). Each source drive IC may be mounted on a source film 140 using methods such as chip on film (COF), chip on plastic (COP), flexible printed circuit (FPC), or flexible flat cable (FFC). One side of the source film 140 may be electrically connected to the display panel 110, and COF wiring may be disposed on the top of the source film 140 to electrically connect each source drive IC to the display panel 110. The source film 140 may be attached to the pads provided in the non-display area NDA of the display panel 110 using an anisotropic conductive film, allowing each source drive IC to be connected to the pads.

The display panel 110 may include a circuit board 150 for electrical connection between the data driver 130 and other devices. The circuit board 150 may include at least one component, but embodiments of the present disclosure are not limited thereto.

The circuit board 150 may be attached source films 140 attached to it. The circuit board 150 may include a plurality of circuits implemented by driving chips. For example, the timing controller 160 may be mounted on the circuit board 150. The circuit board 150 may be a printed circuit board (PCB) or a flexible printed circuit board (FPCB).

The timing controller 160 receives digital video data DATA and timing signals from a host system. The timing signals may include a vertical synchronization signal, a horizontal synchronization signal, a data enable signal, a dot clock, and the like. The vertical synchronization signal is a signal defining one frame period. The horizontal synchronization signal is a signal defining one horizontal period required for supplying the data voltages to the pixels of one horizontal line of the display panel 110. The data enable signal defines a period in which valid data is input. The dot clock is a signal repeated at a predetermined short period.

The timing controller 160 may generate the data control signal DCS for controlling an operation timing of the data driver 130 and the scan control signal GCS for controlling an operation timing of the scan driver 120 based on the timing signals. The timing controller 160 may output the scan control signal GCS to the scan driver 120 and output the digital video data DATA and data control signal DCS to the data driver 130.

The power circuit 170 may generate and supply a plurality of driving voltages required for an operation of all circuit configurations of the light emitting display apparatus by using an input voltage. The power circuit 170 may generate a first power voltage EVDD (or driving power voltage), a second power voltage EVSS (or common power voltage) and a reference power voltage (Vref) (or reference voltage) and supply the generated voltages to the display panel 110. The power circuit 170 may generate and supply various driving voltages required for operations of the gate driver 120, the data driver 130, and the timing controller 160.

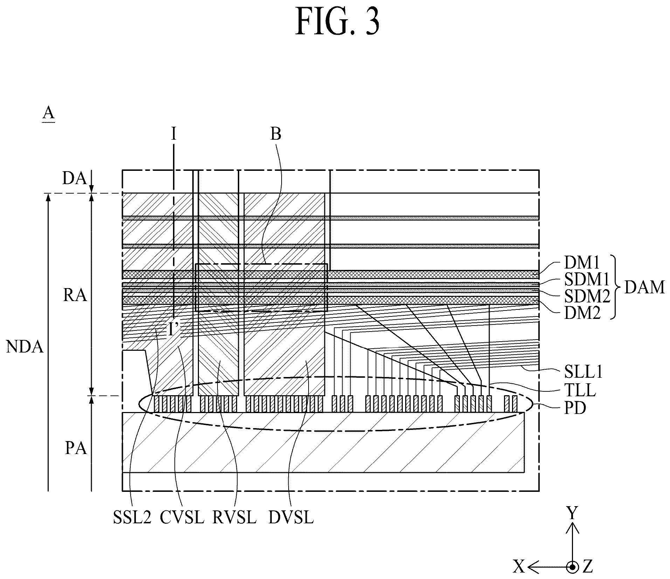

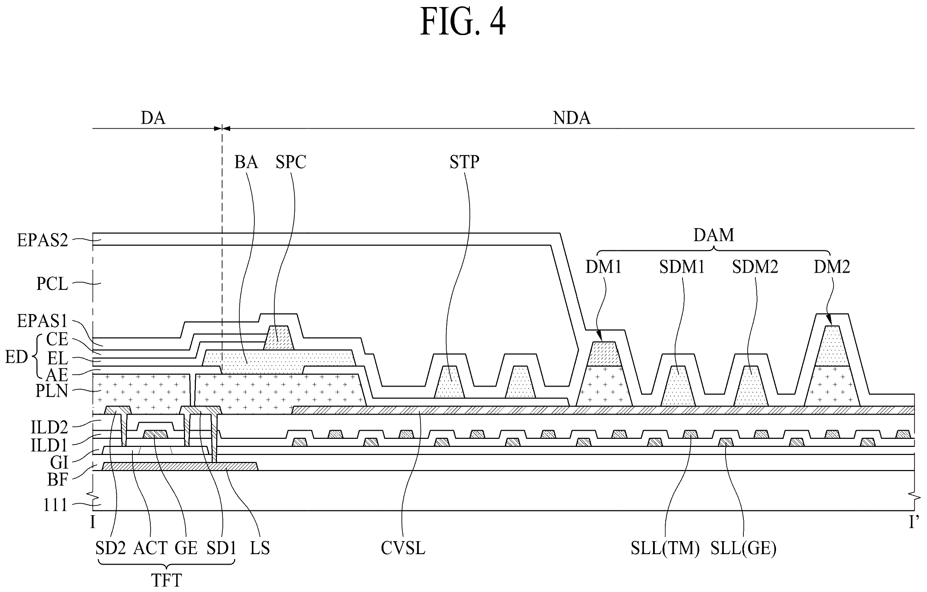

FIG. 3 illustrates a region A shown in FIG. 2 of an embodiment of the disclosure. FIG. 4 is a cross-sectional view taken along line I-I' of FIG. 3 of an embodiment of the disclosure.

Referring to FIGS. 3 and 4, the display panel 110 of an embodiment of the disclosure may include a display area DA for displaying images and a non-display area NDA surrounding the display area DA. The non-display area NDA may include a plurality of dam patterns DAM. The non-display area NDA may include a pad area PA and a routing area RA.

The pad area PA may be disposed at one end of the display panel 110 and may include a plurality of pads PD to which external signals are applied. A plurality of pads PD may be exposed to the outside without being covered by an insulating layer and may be connected to the source film 140. For example, the source film 140 may include a source drive IC of the data driver 130 mounted thereon, and COF wiring electrically connecting the source drive IC to the plurality of pads PD may be disposed. Also, the source film 140 may include COF wiring disposed to transmit the driving control signals and driving power voltages supplied from the circuit board 150. The source film 140 may be attached to the plurality of pads PD arranged in the pad area PA using an anisotropic conductive film, and may electrically connect each pad PD to the COF wiring.

The plurality of pads PD may include power pads to which various driving power voltages are applied and signal pads to which various control voltage signals are applied. The power pads may receive a first power voltage EVDD (or driving power voltage), a second power voltage EVSS (or common power voltage), and a reference power voltage Vref (or reference voltage) supplied from the power circuit 170. For example, the power pads may include a first power pad to which the first power voltage EVDD is applied, a second power pad to which the second power voltage EVSS is applied, and a reference power pad to which the reference power voltage Vref is applied, but embodiments of the disclosure are not limited thereto. For example, the signal pads may include a data signal pad to which a data signal is applied and a gate driving pad to which a scan control signal for controlling the gate driver 120 is applied. Also, the signal pads may further include a touch driving pad through which a touch-related signal for driving a touch sensor is input and output, but embodiments of the disclosure are not limited thereto.

The routing area RA may be disposed between the pad area PA and the display area DA, and may include power voltage shorting lines DVSL, RVSL and CVSL, and various signal link lines SLL1, SLL2 and TLL.

The power voltage shorting lines DVSL, RVSL and CVSL may be connected to power pads disposed in the pad area PA and may extend to the display area DA. The power voltage shorting lines DVSL, RVSL and CVSL may extend in a first direction (or X-axis direction) and a second direction (or Y-axis direction) or may extend in the second direction. For example, the power voltage shorting lines DVSL, RVSL and CVSL may include a first power voltage shorting line DVSL, a second power voltage shorting line CVSL, and a reference voltage shorting line RVSL. For example, the first power voltage shorting line DVSL and the reference voltage shorting line RVSL may extend in the second direction, and the second power voltage shorting line CVSL may extend in the second direction and then be bent and extended in the first direction, but embodiments of the disclosure are not limited thereto.

The signal link lines SLL1, SLL2 and TLL may be connected to signal pads disposed in the pad area PA, and may extend to the display area DA. The signal link lines SLL1, SLL2 and TLL may extend in a first direction, a second direction, or a third direction (or a diagonal direction) between the first and second directions. The signal link lines SLL1, SLL2 and TLL may extend in the third direction, which is directed to a right side or a left side, depending on a position connected to the pad area PA. For example, the signal link lines SLL1, SLL2 and TLL may include gate control signal link line SLL1 and data signal link line SLL2. Also, the signal link lines SLL1, SLL2 and TLL may further include touch signal link line TLL, but embodiments of the disclosure are not limited thereto.

The gate control signal link line SLL1 and the data signal link line SLL2 may extend to different portions of the display area DA and may not overlap with each other in the routing area RA. For example, the gate control signal link line SLL1 may be connected to the scan driver 120 disposed at left or right edge of the display area DA, and the data signal link line SLL2 may be connected to the data lines DL disposed in the display area DA, but embodiments of the disclosure are not limited thereto. Also, the touch signal link line TLL may extend to be connected to touch sensors disposed in the display area DA and may overlap with the gate control signal link line SLL1 and the data signal link line SLL2 in the routing area RA, but embodiments of the disclosure are not limited thereto.

The signal link lines SLL1, SLL2 and TLL may be disposed to overlap with the power voltage shorting lines DVSL, RVSL and CVSL in the routing area RA. For example, the signal link lines SLL1, SLL2 and TLL may be disposed to cross below the power voltage shorting lines DVSL, RVSL and CVSL, or may be disposed to cross above the power voltage shorting lines DVSL, RVSL and CVSL. For example, the gate control signal link line SLL1 and the data signal link line SLL2 may cross below the power voltage shorting lines DVSL, RVSL and CVSL, and the touch signal link line TLL may cross above the power voltage shorting lines DVSL, RVSL and CVSL, but embodiments of the disclosure are not limited thereto. Thus, the gate control signal link line SLL1 and the data signal link line SLL2 are between the substrate 111 and the power voltage shorting lines DVSL, RVSL and CVSL.

The plurality of dam patterns DAM may be disposed to surround the periphery of the display area DA. The plurality of dam patterns DAM may be disposed in the routing area RA between the pad area PA and the display area DA. The plurality of dam patterns DAM may overlap with the power voltage shorting lines DVSL, RVSL and CVSL and the signal link lines SLL1, SLL2 and TLL. The plurality of dam patterns DAM may serve to block the flow of an organic layer PCL comprising the encapsulation portion EPAS1, PCL and EPAS2.

The plurality of dam patterns DAM may be disposed to cross or intersect the power voltage shorting lines DVSL, RVSL and CVSL in a plan view of the display device as shown in FIG. 3. For example, the plurality of dam patterns DAM may extend in the first direction (or X-axis direction), and the power voltage shorting lines DVSL, RVSL and CVSL may extend in the second direction (or Y-axis direction).

The plurality of dam patterns DAM may comprise one or more organic materials. The plurality of dam patterns DAM may include a first dam pattern DM1, which is adjacent to the display area DA and comprises a plurality of organic materials, and a second dam pattern DM2, which is adjacent to the pad area PA and comprises a plurality of organic materials. Also, the plurality of dam patterns DAM may include sub-dam patterns SDM1 and SDM2, which are disposed between the first dam pattern DM1 and the second dam pattern DM2 and comprise at least one organic material.

Referring to FIG. 4, the display panel 110 of an embodiment of the disclosure may include the substrate 111 having the display area DA and the non-display area NDA, at least one insulating layer disposed on the substrate 111, power voltage shorting lines DVSL, RVSL and CVSL, at least one thin film transistor TFT, a light emitting device ED, and an encapsulation portion EPAS1, PCL and EPAS2.

The substrate 111 may include a transparent or opaque plastic film or a glass substrate. For example, the substrate 111 may include the at least one thin film transistor TFT and the light emitting device ED and may be an array substrate or a first substrate, but embodiments of the present disclosure are not limited thereto.

At least one insulating layer BF, GI, ILD1 and ILD2 may be disposed on the substrate 111. For example, a buffer layer BF may be disposed on the substrate 111. The buffer layer BF may be disposed over the entire surface of the substrate 111, may be configured to cover a light blocking layer LS disposed on the substrate 111, and may serve to block foreign substances or moisture penetrating through the substrate 111. At least one of the insulating layers is on a portion of the thin film transistor TFT.

A gate insulating layer GI, first and second interlayer insulating layers ILD1 and ILD2, and at least one thin film transistor TFT may be disposed on the buffer layer BF. For example, the at least one insulating layer BF, GI, ILD1 and ILD2 may be formed as a single layer or a multilayer including an inorganic insulating material such as silicon oxide (SiO_{X}), silicon nitride (SiN_{X}), or aluminum oxide (Al₂O₃), but embodiments of the present disclosure are not limited thereto.

The thin film transistor TFT may be disposed on the buffer layer BF in the display area DA. The thin film transistor TFT may comprise an active layer ACT, a gate electrode GE, and source/drain electrodes SD1 and SD2.

The active layer ACT may be disposed on the buffer layer BF and may comprise a semiconductor material based on an oxide semiconductor such as IGZO (indium-gallium-zinc-oxide), or a semiconductor material based on silicon, such as amorphous silicon or polycrystalline silicon, but embodiments of the present disclosure are not limited thereto. The active layer ACT may include a source region, a drain region, and a channel region between the source and drain regions.

The gate insulating layer GI may be patterned and formed only on the channel region of the active layer ACT or may be disposed over the entire buffer layer BF including the active layer ACT.

The gate electrode GE may be disposed on the gate insulating layer GI to overlap with the channel region of the active layer ACT and may be patterned together with the gate insulating layer GI. The gate electrode GE may be formed of the same material in the same layer as the scan line SL disposed in the display area DA. For example, the gate electrode GE may be formed of the same material in the same layer as the signal link line SLL disposed in the non-display area NDA, but embodiments of the disclosure are not limited thereto.

A first interlayer insulating layer ILD1 may be disposed on the gate insulating layer GI including the gate electrode GE, and an intermediate metal layer TM may be disposed on the first interlayer insulating layer ILD1. The intermediate metal layer TM may be formed as a connection pattern (or jumper pattern) connecting the gate electrode GE pattern and the source and drain electrode SD pattern between the gate electrode GE and the source and drain electrodes SD or may be formed as a part of an electrode included in a storage capacitor. For example, the intermediate metal layer TM may be formed of the same material in the same layer as the signal link line SLL disposed in the non-display area NDA, but embodiments of the disclosure are not limited thereto.

A plurality of signal link lines SLL may be disposed on the gate insulating layer GI and the first interlayer insulating layer ILD1 in the non-display area NDA. For example, the plurality of signal link lines SLL may be disposed in the routing area RA between the display area DA and the pad area PA. The plurality of signal link lines SLL may comprise a first signal link line formed of the same material as the gate electrode GE on the gate insulating layer GI and a second signal link line formed of the same material as the intermediate metal layer TM on the first interlayer insulating layer ILD1. The first and second signal link lines may be disposed alternately or may be disposed to overlap each other, but embodiments of the present disclosure are not limited thereto.

The second interlayer insulating layer ILD2 may be disposed on the first interlayer insulating layer ILD1 that includes the intermediate metal layer TM, and the source/drain electrodes SD1 and SD2 may be disposed on the second interlayer insulating layer ILD2. The source/drain electrodes SD1 and SD2 may include a first source/drain electrode SD1 and a second source/drain electrode SD2. For example, the first source/drain electrode SD1 may be electrically connected to a first region (source or drain region) of the active layer ACT. Also, the first source/drain electrode SD1 may be electrically connected to the light blocking layer LS on the substrate 111. The second source/drain electrode SD2 may be electrically connected to a second region (source or drain region) of the active layer ACT. For example, the source/drain electrodes SD1 and SD2 may be formed of the same material in the same layer as the power voltage shorting lines DVSL, RVSL and CVSL disposed in the non-display area NDA, but embodiments of the present disclosure are not limited thereto.

In the non-display area NDA, the power voltage shorting lines DVSL, RVSL and CVSL may be disposed on the second interlayer insulating layer ILD2. For example, the power voltage shorting lines DVSL, RVSL and CVSL may be disposed in the routing area RA between the display area DA and the pad area PA. The power voltage shorting lines DVSL, RVSL and CVSL may be formed of the same material as the source/drain electrodes SD1 and SD2 on the second interlayer insulating layer ILD2, but embodiments of the present disclosure are not limited thereto.

A planarization layer PLN may be disposed on the second interlayer insulating layer ILD2 in the display area DA. The planarization layer PLN may serve to planarize step differences caused by the thin-film transistor TFT, the scan line SL, and the data line DL disposed on the substrate 111, and may be formed of an organic insulating material. For example, the planarization layer PLN may be formed of an organic material such as acryl resin, epoxy resin, phenolic resin, polyamide resin, or polyimide resin, but embodiments of the disclosure are not limited thereto.

A light emitting device ED (e.g., a light-emitting element) comprising a pixel electrode AE, an emission layer EL, and a common electrode CE may be disposed on the planarization layer PLN in the display area DA. Also, a bank layer BA configured to define an opening area (or an emission area) of the pixel electrode AE may further be disposed on the planarization layer PLN. For example, the bank layer BA may be configured to cover an edge of the pixel electrode AE. The bank layer BA may be disposed between the pixel electrode AE and the emission layer EL. Meanwhile, a spacer SPC may be further disposed on the bank layer BA. The spacer SPC may serve to maintain a gap between the light emitting device ED and the encapsulation portion EPAS1, PCL and EPAS2 in the display area DA, and may support the encapsulation portion EPAS1, PCL and EPAS2, but embodiments of the disclosure are not limited thereto.

The encapsulation portion EPAS1, PCL and EPAS2 may be disposed on the light emitting device ED and the bank layer BA to protect the light emitting device ED. The encapsulation portion EPAS1, PCL and EPAS2 may include a first inorganic layer EPAS1, an organic layer PCL, and a second inorganic layer EPAS2. The first inorganic layer EPAS1 may be disposed on the common electrode CE of the light emitting device ED, the organic layer PCL may be disposed on the first inorganic layer EPAS1, and the second inorganic layer EPAS2 may be disposed on the organic layer PCL or the first inorganic layer EPAS1 to cover the organic layer PCL.

The encapsulation portion EPAS1, PCL and EPAS2 may be disposed to cover the entire display area DA so as to sufficiently cover the light emitting device ED and may extend to be disposed over at least a portion of the non-display area NDA. For example, the encapsulation portion EPAS1, PCL and EPAS2 may extend to the non-display area NDA, excluding the pad area PA, and may be disposed to overlap with the power voltage shorting lines DVSL, RVSL and CVSL disposed in the routing area RA of the non-display area NDA. In the routing area RA, the encapsulation portion EPAS1, PCL and EPAS2 may be configured to cover the power voltage shorting lines DVSL, RVSL and CVSL.

The plurality of dam patterns DAM may be disposed in the non-display area NDA on the substrate 111. For example, the plurality of dam patterns DAM may be disposed in the routing area RA of the non-display area NDA. In the routing area RA, the plurality of dam patterns DAM may serve to block the flow of the organic layer PCL of the encapsulation portion EPAS1, PCL and EPAS2. For example, the plurality of dam patterns DAM may be disposed to surround the periphery of the display area DA to block the flow of the organic layer PCL of the encapsulation portion EPAS1, PCL, and EPAS2. Accordingly, the organic layer PCL of the encapsulation portion EPAS1, PCL and EPAS2 may be disposed from the display area DA to the non-display area NDA, where the plurality of dam patterns DAM are disposed. For example, the organic layer PCL may be disposed up to a portion of the routing area RA, and the first and second inorganic layers EPAS1 and EPAS2 may be disposed to extend to the end of the routing area RA. For example, the organic layer PCL and the first inorganic layer EPAS1 may be disposed up to a portion of the routing area RA, and the second inorganic layer EPAS2 may be disposed to extend to the end of the routing area RA, but embodiments of the present disclosure are not limited thereto.

The plurality of dam patterns DAM may be disposed to overlap with the power voltage shorting lines DVSL, RVSL and CVSL. For example, at least a portion of the plurality of dam patterns DAM may be disposed on the power voltage shorting lines DVSL, RVSL and CVSL. The plurality of dam patterns DAM and the power voltage shorting lines DVSL, RVSL and CVSL may be disposed to intersect with each other in a plan view of the display device.

The plurality of dam patterns DAM may include a first dam pattern DM1 adjacent to the display area DA and a second dam pattern DM2 adjacent to the pad area PA. For example, the first dam pattern DM1 is closer to the display area DA than the second dam pattern DM2 and the second dam pattern DM2 is closer to the pad area PA than the first dam pattern DM1. Also, the plurality of dam patterns DAM may include at least one sub-dam pattern SDM1 and SDM2 disposed between the first and second dam patterns DM1 and DM2. The at least one sub-dam pattern SDM1 and SDM2 may include a first sub-dam pattern SDM1 adjacent to the first dam pattern DM1 and a second sub-dam pattern SDM2 adjacent to the second dam pattern DM2, but embodiments of the disclosure are not limited thereto. For example, the first sub-dam pattern SDM1 is closer to the first dam pattern DM1 than the second sub-dam pattern SDM2 and the second sub-dam pattern SDM2 is closer to the second dam pattern DM2 than the first sub-dam pattern SDM1. Meanwhile, the non-display area NDA may further include at least one stopper STP disposed between the display area DA and the first dam pattern DM1. The at least one stopper STP may serve to block the flow of the organic layer PCL of the encapsulation portion EPAS1, PCL and EPAS2, but embodiments of the disclosure are not limited thereto.

The first dam pattern DM1 may contact the first inorganic layer EPAS1, the organic layer PCL, and the second inorganic layer EPAS2 of the encapsulation portion EPAS1, PCL and EPAS2. The second dam pattern DM2 and the at least one sub-dam pattern SDM1 and SDM2 may contact at least one of the first and second inorganic layers EPAS1 and EPAS2 of the encapsulation portion EPAS1, PCL and EPAS2. For example, the second dam pattern DM2 and the at least one sub-dam pattern SDM1 and SDM2 may contact the first inorganic layer EPAS1 or the second inorganic layer EPAS2, but embodiments of the disclosure are not limited thereto.

The plurality of dam patterns DAM may comprise at least a portion of the planarization layer PLN, the bank layer BA, and the spacer SPC. For example, the first dam pattern DM1 may comprise the planarization layer PLN and the spacer SPC, and the second dam pattern DM2 may comprise the planarization layer PLN and the bank layer BA. Also, at least one of the sub-dam patterns SDM1 and SDM2 may comprise the bank layer BA, but embodiments of the present disclosure are not limited thereto.

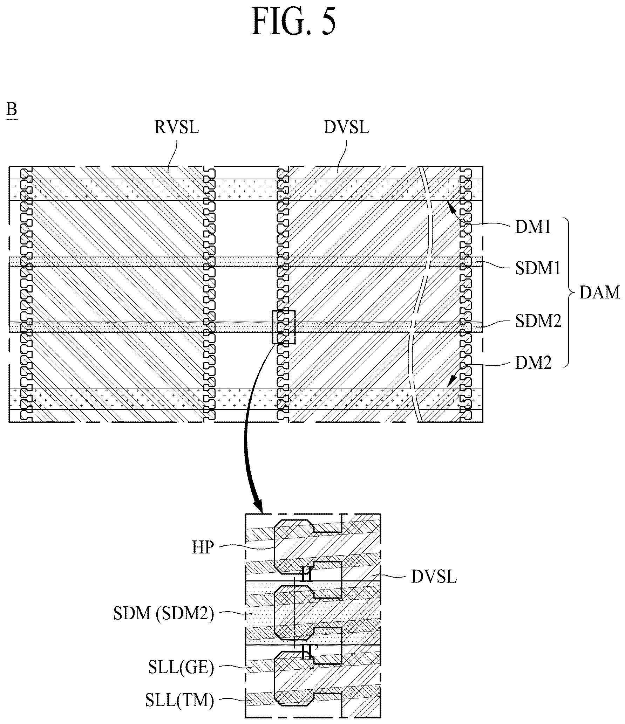

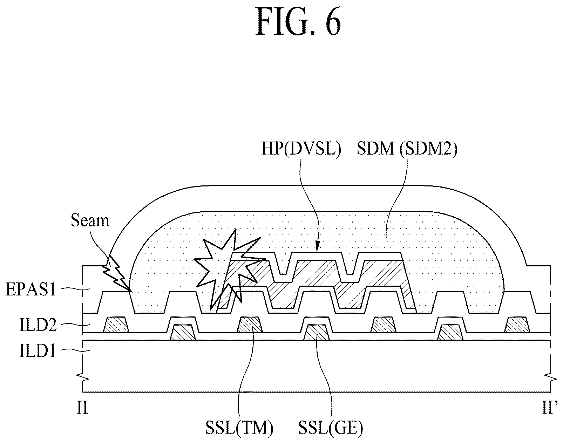

FIG. 5 illustrates a region B shown in FIG. 3 of an embodiment of the disclosure. FIG. 6 is a cross-sectional view taken along line II-II' of FIG. 5 of an embodiment of the disclosure.

Referring to FIGS. 5 and 6, the non-display area NDA of an embodiment of the disclosure may comprise a plurality of dam patterns DAM and power voltage shorting lines DVSL, RVSL and CVSL.

The power voltage shorting lines DVSL, RVSL and CVSL may be disposed on a second interlayer insulating layer ILD2 in the non-display area NDA. The power voltage shorting lines DVSL, RVSL and CVSL may extend in a second direction (or Y-axis direction). The power voltage shorting lines DVSL, RVSL and CVSL may include a first power voltage shorting line DVSL, a second power voltage shorting line CVSL, and a reference power voltage shorting line RVSL. For example, as shown in FIG. 5, the first power voltage shorting line DVSL may be disposed adjacent to the reference power voltage shorting line RVSL. The first power voltage shorting line DVSL and the reference power voltage shorting line RVSL may be spaced apart from each other by a predetermined interval. The first power voltage shorting line DVSL and the reference power voltage shorting line RVSL may be disposed parallel to each other in the second direction.

The plurality of signal link lines SLL extending from the pad area PA may be disposed to cross below the power voltage shorting lines DVSL, RVSL and CVSL. The plurality of signal link lines SLL may comprise a first signal link line formed of the same material as a gate electrode GE on a gate insulating layer GI, and a second signal link line formed of the same material as an intermediate metal layer TM on a first interlayer insulating layer ILD1. The first and second signal link lines may be alternately disposed or may be disposed to overlap each other.

Each of the power voltage shorting lines DVSL, RVSL and CVSL may comprise a plurality of fine protrusion patterns HP having a hammer shape to secure excellent electrical characteristics. For example, each of the power voltage shorting lines DVSL, RVSL and CVSL may increase a length and an area of an edge portion through a plurality of fine protrusion patterns HP formed at the edge portion. Accordingly, each of the power voltage shorting lines DVSL, RVSL and CVSL may reduce electrical resistance and improve thermal dissipation efficiency. In one embodiment, the hammer shape includes a handle portion and a head portion at one end of the handle portion. The head portion has a width that is wider than a width of the handle portion.

The plurality of dam patterns DAM may be disposed to cross the power voltage shorting lines DVSL, RVSL and CVSL. For example, as shown in FIG. 5, the plurality of dam patterns DAM may be disposed to cross the first power voltage shorting line DVSL and the reference power voltage shorting line RVSL. The plurality of dam patterns DAM may be disposed on the first power voltage shorting line DVSL and the reference power voltage shorting line RVSL. For example, the plurality of dam patterns DAM may be disposed on at least a portion of the first power voltage shorting line DVSL and the reference power voltage shorting line RVSL.

The plurality of dam patterns DAM may include a first dam pattern DM1 adjacent to the display area DA and a second dam pattern DM2 adjacent to the pad area PA, and may include at least one sub-dam pattern SDM1 and SDM2 disposed between the first and second dam patterns DM1 and DM2.

The at least one sub-dam pattern SDM1 and SDM2 of an embodiment of the disclosure may be formed of a single organic material and may be directly disposed on the first power voltage shorting line DVSL and the reference power voltage shorting line RVSL. For example, the at least one sub-dam pattern SDM1 and SDM2 may be formed of the same material as the bank layer BA.

The bank layer BA and the at least one sub-dam pattern SDM1 and SDM2 may decrease in adhesive characteristics in a high-temperature and high-humidity environment. Accordingly, the at least one sub-dam pattern SDM1 and SDM2 in contact with the first power voltage shorting line DVSL and the reference power voltage shorting line RVSL may be separated from the first power voltage shorting line DVSL and the reference power voltage shorting line RVSL, leading to a film lifting phenomenon.

The film lifting phenomenon as described above may form cracks (or seams) in the inorganic layer EPAS1 and EPAS2 of the encapsulation portion covering the at least one sub-dam pattern SDM1 and SDM2. Such cracks may provide a diffusion path through which moisture from the external environment may penetrate into the interior, and the infiltrated moisture may corrode the power voltage shorting lines DVSL, RVSL and CVSL, leading to electrolytic corrosion failure. For example, electrolytic corrosion failure mainly occurs in the first power voltage shorting line DVSL that supplies a high-voltage power, which may degrade the reliability of the light emitting display apparatus.

Accordingly, the inventors have invented a light emitting display apparatus having a robust bezel structure capable of preventing film lifting or crack defects of the encapsulation film in high-temperature and high-humidity environments through various studies and experiments.

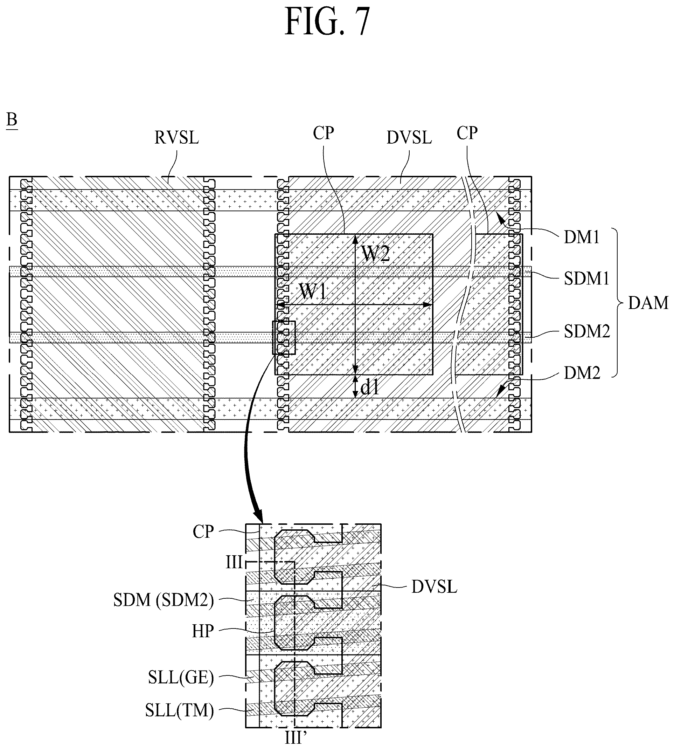

Hereinafter, a light emitting display apparatus of one or more embodiments of the disclosure having a robust bezel structure will be described in more detail with reference to FIGS. 7 to 11.

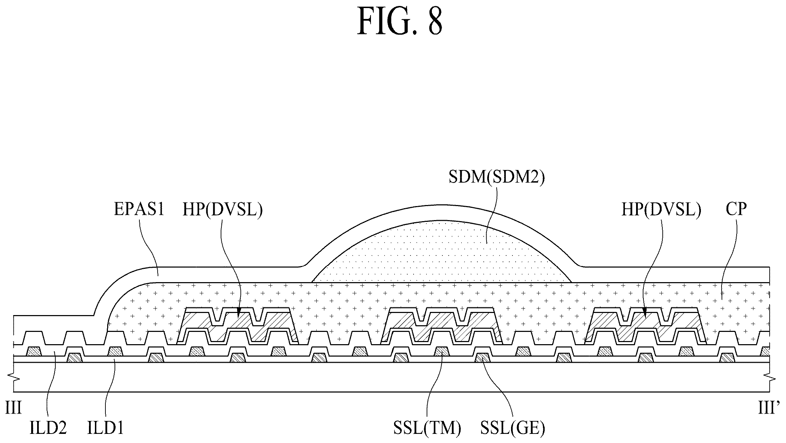

FIG. 7 illustrates a region B shown in FIG. 3 of one embodiment of the disclosure. FIG. 8 is a cross-sectional view taken along line III-III' of FIG. 7 of one embodiment of the disclosure.

Referring to FIGS. 7 and 8, a non-display area NDA of one embodiment of the disclosure may include a plurality of dam patterns DAM, power voltage shorting lines DVSL, RVSL and CVSL, and a cover pattern CP.

The cover pattern CP of one embodiment of the disclosure may be disposed between the plurality of dam patterns DAM. For example, the plurality of dam patterns DAM may include a first dam pattern DM1 and a second dam pattern DM2, and the cover pattern CP may be disposed between the first and second dam patterns DM1 and DM2. The cover pattern CP may further improve the adhesion and prevent the lifting effect to thereby avoid the introduction of humidity.

For example, the first dam pattern DM1 is spaced apart from a first side of the cover pattern CP and the second dam pattern DM2 is spaced apart from a second side of the cover pattern CP such that the cover pattern CP is between the first dam pattern DM1 and the second dam pattern DM2.

The plurality of dam patterns DAM may include at least one sub-dam pattern SDM1 and SDM2 disposed between the first and second dam patterns DM1 and DM2. The at least one sub-dam pattern SDM1 and SDM2 may include a first sub-dam pattern SDM1 adjacent to the first dam pattern DM1 and a second sub-dam pattern SDM2 adjacent to the second dam pattern DM2.

The cover pattern CP may be disposed to overlap the first and second sub-dam patterns SDM1 and SDM2 between the first and second dam patterns DM1 and DM2. For example, the cover pattern CP is between the power voltage shorting line and at least one of the first and second sub-dam patterns SDM1 and SDM2.

The cover pattern CP may be formed of a material at least partially different from that of the plurality of dam patterns DAM. Due to the different material a better adhesion might be achieved.

For example, the cover pattern CP may be formed of an organic material different from the first and second sub-dam patterns SDM1 and SDM2. The cover pattern CP may be formed of the same material as the planarization layer PLN. For example, the cover pattern CP includes a material that has properties that allow for better adhesion to the power voltage shorting line than the first and second sub-dam patterns SDM1 and SDM2. Thus, the lifting off effect might be reduced.

The cover pattern CP may be disposed on the second interlayer insulating layer ILD2 to cover at least a portion of the first power voltage shorting line DVSL. The cover pattern CP may be configured to cover at least a portion of the fine protrusion pattern HP of the first power voltage shorting line DVSL. In one embodiment, the cover pattern CP is in direct contact with at least a portion of the power voltage shorting line such as the first power voltage shorting line DVSL. The first and second sub-dam patterns SDM1 and SDM2 may be disposed on the cover pattern CP, and the cover pattern CP may be disposed between the first and second sub-dam patterns SDM1 and SDM2 and the first power voltage shorting line DVSL. At least a portion of the encapsulation layer overlaps the cover pattern CP and at least one of the first and second sub-dam patterns SDM1 and SDM2.

The cover pattern CP may be an island pattern that covers one edge of the power voltage shorting lines DVSL, RVSL and CVSL. For example, the cover pattern CP may be an island pattern that covers one edge of the first power voltage shorting line DVSL. For example, the cover pattern CP may be disposed at a left edge of the first power voltage shorting line DVSL in the first direction (or X-axis direction). Also, the cover pattern CP may be disposed at a right edge of the first power voltage shorting line DVSL in the first direction.

The island pattern of the cover pattern CP may be formed in a polygonal shape having a first width W1 and a second width W2. For example, the cover pattern CP may cover the fine protruding pattern HP of the first power voltage shorting line DVSL and may have the first width W1 extending in the first direction (or X-axis direction), and may have the second width W2 extending in the second direction (or Y-axis direction) between the first and second dam patterns DM1 and DM2. The first width W1 of the cover pattern CP may be equal to or greater than the second width W2. For example, the first width W1 of the cover pattern CP may be greater than the second width W2.

The second width W2 of the cover pattern CP may be configured to have a width that is spaced from the first and second dam patterns DM1 and DM2 by a first distance d1. For example, the first distance d1 may be the distance corresponding to two of the plurality of fine protrusion patterns HP. For example, the second width W2 of the cover pattern CP may be a width that has the first distance d1 from the first dam pattern DM1 and the first distance d1 from the second dam pattern DM2 between the first and second dam patterns DM1 and DM2.

In one embodiment of the disclosure, the cover pattern CP may cover an edge of the first power voltage shorting line DVSL and may be formed of the planarization layer PLN that has relatively better adhesion properties than the first and second sub-dam patterns SDM1 and SDM2, thereby minimizing film lifting of the first and second sub-dam patterns SDM1 and SDM2 or cracking defects of the inorganic layers EPAS1 and EPAS2, and increasing or minimizing a moisture permeation path of the edge portion of the first power voltage shorting line DVSL between the first and second dam patterns DM1 and DM2. Accordingly, by improving the moisture permeation reliability of the plurality of dam patterns DAM, electrolytic corrosion failure of the first power voltage shorting line DVSL may be effectively prevented, and the light emitting display apparatus with enhanced reliability in high-temperature and high-humidity environments may be realized.

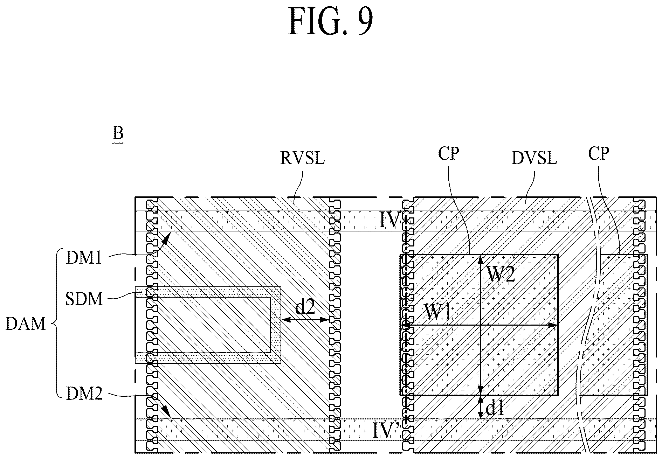

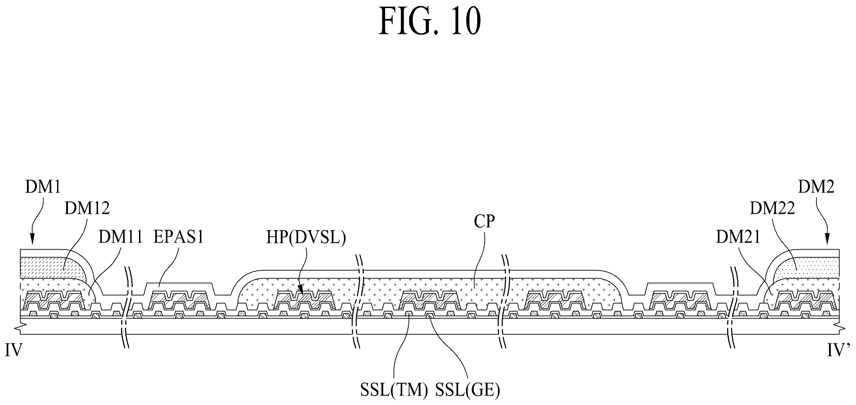

FIG. 9 illustrates a region B shown in FIG. 3 of another embodiment of the disclosure. FIG. 10 is a cross-sectional view taken along line IV-IV' of FIG. 9 of another embodiment of the disclosure.

Referring to FIGS. 9 and 10, a non-display area NDA of another embodiment of the disclosure may include a plurality of dam patterns DAM, power voltage shorting lines DVSL, RVSL and CVSL, and a cover pattern CP.

The cover pattern CP of another embodiment of the disclosure may be disposed between the plurality of dam patterns DAM. For example, the cover pattern CP may be disposed between the first and second dam patterns DM1 and DM2. The plurality of dam patterns DAM may include at least one sub-dam pattern SDM disposed between the first and second dam patterns DM1 and DM2. The cover pattern CP may not overlap with the at least one sub-dam pattern SDM.

The at least one sub-dam pattern SDM of another embodiment of the disclosure may be configured in a closed loop shape between the first and second dam patterns DM1 and DM2. For example, the at least one sub-dam pattern SDM may be disposed in a portion excluding the first power voltage shorting line DVSL.

The at least one sub-dam pattern SDM may be disposed to be spaced by a second distance d2 from an edge of the reference power voltage shorting line RVSL adjacent to the first power voltage shorting line DVSL. For example, the at least one sub-dam pattern SDM may be formed of the same material as the bank layer BA.

In another embodiment of the disclosure, the cover pattern CP may cover the edge of the first power voltage shorting line DVSL and may be formed of the planarization layer PLN, which has relatively better adhesion properties than the first and second sub-dam patterns SDM1 and SDM2, thereby minimizing film lifting of the cover pattern CP or cracking defects of the inorganic layers EPAS1 and EPAS2. Also, the at least one sub-dam pattern SDM, which has relatively lower adhesion properties than the cover pattern CP, may avoid being disposed at the edge of the reference power voltage shorting line RVSL, which is susceptible to moisture permeation, thereby minimizing film lifting of the at least one sub-dam pattern SDM or cracking defects of the inorganic layers EPAS1 and EPAS2, and increasing or minimizing a moisture permeation path of the edge portion of the reference power voltage shorting line RVSL. Accordingly, by improving the moisture permeation reliability of the plurality of dam patterns DAM, electrolytic corrosion failures of the first power voltage shorting line DVSL and the reference power voltage shorting line RVSL may be effectively prevented, and the light-emitting display apparatus with enhanced reliability in high-temperature and high-humidity environments may be realized.

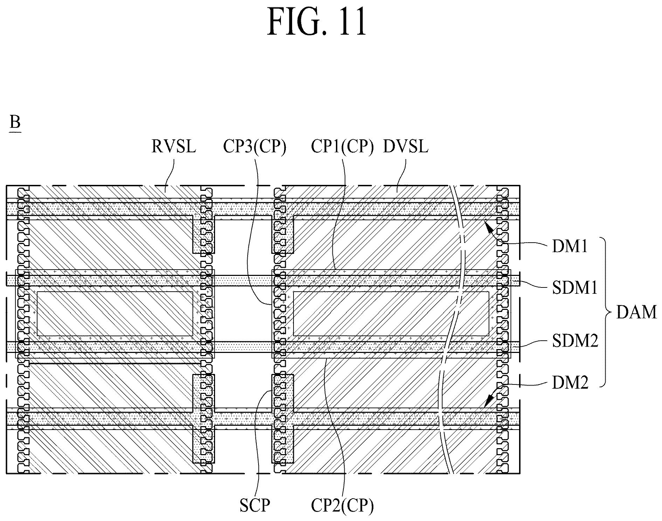

FIG. 11 illustrates a region B shown in FIG. 3 of another embodiment of the disclosure.

Referring to FIG. 11, a non-display area NDA of another embodiment of the disclosure may include a plurality of dam patterns DAM, power voltage shorting lines DVSL, RVSL and CVSL, and a cover pattern CP.

The cover pattern CP of another embodiment of the disclosure may be disposed between the plurality of dam patterns DAM. For example, the cover pattern CP may be disposed between the first and second dam patterns DM1 and DM2.

The cover pattern CP may be configured to cover one side and another side edges of the power voltage shorting lines DVSL, RVSL and CVSL in a first direction (or X-axis direction). For example, the cover pattern CP may be configured in a closed-loop shape. The cover pattern CP may include a first cover pattern CP1 overlapping with the first sub-dam pattern SDM1, a second cover pattern CP2 overlapping with the second sub-dam pattern SDM2, and a third cover pattern CP3 overlapping with one side and another side edges of the power voltage shorting line DVSL, RVSL and CVSL.

The first cover pattern CP1 may extend in the first direction to overlap with the first sub-dam pattern SDM1, the second cover pattern CP2 may extend in the first direction to overlap with the second sub-dam pattern SDM2, and the third cover pattern CP3 may extend in the second direction to overlap with the edges of the power voltage shorting line DVSL, RVSL and CVSL, and may be connected to the first and second cover patterns CP1 and CP2. For example, the first to third cover patterns CP1 to CP3 may each cover a first side edge and a second side edge of the power voltage shorting line.

The cover pattern CP of another embodiment of the disclosure may further include sub-cover patterns SCP protruding from each of the first and second dam patterns DM1 and DM2.

The sub-cover pattern SCP may be formed to protrude in the second direction from a portion of the first dam pattern DM1 that intersects with an edge of the power voltage shorting line DVSL, RVSL and CVSL. For example, the sub-cover pattern SCP may be configured to be spaced apart from the first cover pattern CP1 by a predetermined distance. For example, the sub-cover pattern SCP connected to the first dam pattern DM1 may be configured to protrude downward in the second direction.

The sub-cover pattern SCP may be formed to protrude in the second direction from a portion of the second dam pattern DM2 that intersects with an edge of the power voltage shorting line DVSL, RVSL and CVSL. For example, the sub-cover pattern SCP may be configured to be spaced apart from the second cover pattern CP2 by a predetermined distance. For example, the sub-cover pattern SCP connected to the second dam pattern DM2 may be configured to protrude both upward and downward in the second direction.

In another embodiment of the disclosure, the cover pattern CP may cover the edges of the power voltage shorting lines DVSL, RVSL and CVSL, and may be formed of the planarization layer PLN that has relatively better adhesion properties than the first and second sub-dam patterns SDM1 and SDM2, thereby minimizing film lifting of the first and second sub-dam patterns SDM1 and SDM2 and the cover pattern CP or cracking defects of the inorganic layers EPAS1 and EPAS2. Also, the moisture permeation path of the edge portion of the power voltage shorting lines DVSL, RVSL and CVSL between the first and second dam patterns DM1 and DM2 may be increased or minimized. Accordingly, by improving the moisture permeation reliability of the plurality of dam patterns DAM, electrolytic corrosion failures of the power voltage shorting lines DVSL, RVSL and CVSL may be effectively prevented, and the light-emitting display apparatus with enhanced reliability in high-temperature and high-humidity environments may be realized.

The above-described feature, structure, and effect of the disclosure are included in at least one embodiment of the disclosure, but are not limited to only one embodiment. Furthermore, the feature, structure, and effect described in at least one embodiment of the present disclosure may be implemented through combination or modification of other embodiments by those skilled in the art. Therefore, content associated with the combination and modification should be construed as being within the scope of the disclosure.

It will be apparent to those skilled in the art that various modifications and variations can be made in the disclosure without departing from the scope of the disclosures. Thus, it is intended that the disclosure covers the modifications and variations of this disclosure provided they come within the scope of the appended claims and their equivalents.

## Claims

1. A light emitting display apparatus comprising:
a substrate (111) including a display area (DA) and a non-display area (NDA) outside the display area (DA);
at least one insulating layer (ILD1, ILD2) on the substrate (111);
a power voltage shorting line (DVSL, RVSL, CVSL) configured to supply a power voltage, wherein the power voltage shorting line (DVSL, RVSL, CVSL) is provided on the at least one insulating layer (ILD1, ILD2) in the non-display area (NDA);
a dam pattern (DAM) in the non-display area (NDA),
the dam pattern (DAM) comprising one or more organic materials and overlaps the power voltage shorting line (DVSL, RVSL, CVSL); and
a cover pattern (CP) between the dam pattern (DAM) in the non-display area (NDA), the cover pattern (CP) covering an edge portion of the power voltage shorting line (DVSL, RVSL, CVSL).

2. The light emitting display apparatus of claim 1, wherein the power voltage shorting line (DVSL, RVSL, CVSL) and the dam pattern (DAM) intersect each other in a plan view, preferably the dam pattern (DAM) extend in a first direction and the power voltage shorting line (DVSL, RVSL, CVSL) extends in a second direction that is different from the first direction.

3. The light emitting display apparatus of claim 1 or 2, wherein the power voltage shorting line (DVSL, RVSL, CVSL) includes a fine protrusion pattern (HP) at the edge portion covered by the cover pattern (CP), and/or a fine protrusion pattern (HP) includes a hammer shape including a handle portion and a head portion at an end of the handle portion, the head portion having a width that is wider than a width of the handle portion.

4. The light emitting display apparatus of any one of the preceding claims, wherein the cover pattern (CP) comprises an organic material that is different from the one or more organic materials of the dam pattern (DAM).

5. The light emitting display apparatus of any one of the preceding claims, wherein the cover pattern (CP) is an island pattern that covers the edge portion of the power voltage shorting line (DVSL, RVSL, CVSL) but does not cover another edge portion of the power voltage shorting line (DVSL, RVSL, CVSL) that is spaced apart from the edge portion.

6. The light emitting display apparatus of any one of the preceding claims, wherein the cover pattern (CP) includes a first cover pattern (CP1) and a second cover pattern (CP2), preferably the first cover pattern (CP1) covers the edge portion of the power voltage shorting line (DVSL, RVSL, CVSL) and the second cover pattern (CP2) covers the other edge portion of the power voltage shorting line (DVSL, RVSL, CVSL).

7. The light emitting display apparatus of any one of the preceding claims, wherein the dam pattern (DAM) includes:
a first dam pattern (DM1) adjacent to the display area (DA), the first dam pattern (DM1) comprising a plurality of organic materials; and
a second dam pattern (DSM2) adjacent to an edge of the substrate (111), the second dam pattern (DM2) being closer to the edge of the substrate (111) than the first dam pattern (DM1), the first dam pattern (DM1) being closer to the display area (DA) than the second dam pattern (DM2), and the second dam pattern (DM2) comprising a plurality of organic materials,
wherein the cover pattern (CP) is between the first dam pattern (DM1) and the second dam pattern (DM2) and comprises an organic material that is different from the plurality of organic materials of the first dam pattern (DM1) and the plurality of organic materials of the second dam pattern (DM2).

8. The light emitting display apparatus of any one of the preceding claims, wherein the dam pattern (DM1, DM2) further include at least one sub-dam pattern (SDM1) between the first dam pattern (DM1) and the second dam pattern (DM2), and the at least one sub-dam pattern (SDM1) comprises an organic material that is different from the organic material of the cover pattern (CP), preferably the cover pattern (CP) overlaps at least a portion of the at least one sub-dam pattern (SDM1) and the at least one sub-dam pattern (SDM1) is on the cover pattern (CP), and/or the cover pattern (CP) includes a material having better adhesion to the power voltage shorting line (DVSL, RVSL, CVSL) than a material of the at least one sub-dam pattern (SDM1).

9. The light emitting display apparatus of claim 8, wherein the cover pattern (CP) is non-overlapping with the at least one sub-dam pattern (SDM1) and the at least one sub-dam pattern (SDM1) has a closed loop shape between the first dam pattern (DM1) and the second dam pattern (DM2).

10. The light emitting display apparatus of claim 8 or 9, wherein the power voltage shorting line (DVSL, RVSL, CVSL) includes:
a first power voltage shorting line (DVSL) configured to supply a high potential power voltage; and
a second power voltage shorting line (CVSL) configured to supply a low potential power voltage lower than the high potential power voltage, and
wherein the at least one sub-dam pattern (SDM1) is non-overlapping with the first power voltage shorting line (DVSL) and overlapping with the second power voltage shorting line (CVSL).

11. The light emitting display apparatus of claim 8, 9 or 10, wherein the at least one sub-dam pattern (SDM1) includes a first sub-dam pattern (SDM1) and a second sub-dam pattern (SDM2) that are spaced apart from each other and are parallel to each other, and the cover pattern (CP) overlaps with the first sub-dam pattern (SDM1) and the second sub-dam pattern (SDM2).

12. The light emitting display apparatus of any one of the preceding claims, wherein the cover pattern (CP) has a closed-loop shape and covers a first side edge and a second side edge of the power voltage shorting line (DVSL, RVSL, CVSL).

13. The light emitting display apparatus of any one of the preceding claims 7-12, wherein each of the first dam pattern (DM1) and the second dam pattern (DM2) extends in a first direction and the cover pattern (CP) further includes a sub-cover pattern (SCP) protruding from each of the first dam pattern (DM1) and the second dam pattern (DM2) in a second direction that is different from the first direction.

14. The light emitting display apparatus of any one of the preceding claims, further comprising:
a planarization layer (PLN) on the at least one insulating layer (ILD1, ILD2) in the display area (DA);
a light-emitting device (ED) on the planarization layer (PLN),
a pixel circuit between the substrate (111) and the planarization layer (PLN), the pixel circuit connected to the light-emitting device (ED);
a bank layer (BA) including an opening area of a pixel electrode (AE); and
an encapsulation portion (EPAS1, EPAS2, PCL) that covers the light-emitting device (ED) and the bank layer (BA),
wherein the power voltage shorting line (DVSL, RVSL, CVSL) is configured to supply the power voltage to a first power voltage line connected to the pixel circuit,
preferably the dam pattern (DAM) comprise a same material as at least a portion of the planarization layer (PLN) and the bank layer (BA) and the cover pattern (CP) comprises a same material as the planarization layer (PLN) and/or the dam pattern (DAM) includes at least one sub-dam pattern (SDM1) comprising a same material as the bank layer (BA) and the cover pattern (CP) overlaps the at least one sub-dam pattern (SDM1).

15. The light emitting display apparatus of any one of the preceding claims, wherein the non-display area further includes a pad area (PA) and the light emitting display apparatus further includes:
a plurality of voltage signal lines (SSL1, SLL2) extending from the pad area (PA) and are provided between the power voltage shorting line (DVSL, RVSL, CVSL) and the substrate (110),
wherein the dam pattern (DAM) and the power voltage shorting line (DVSL, RVSL, CVSL) are between the display area (DA) and the pad area (PA).
